# EUROPEAN PATENT APPLICATION

(11) **EP 4 525 304 A1**
(43) Date of publication of application: **19.03.2025**
(21) Application number: 23197554.1
(22) Date of filing: 14.09.2023
(51) Int. Cl.: H03H 11/18, H03H 11/22, H03F 3/26, H03F 3/50

(54) **POLYPHASE FILTER CIRCUITRY**

(71) Applicant: Socionext Inc., Yokohama-shi Kanagawa 222-0033 (JP)
(72) Inventor: MIKHAEL, David Hany Gaied, 63225 Langen (DE); GERMANN, Bernd Hans, 63225 Langen (DE); DOLDAN LORENZO, Ricardo, 63225 Langen (DE)
(74) Representative: Haseltine Lake Kempner LLP

(57) **Abstract**

Polyphase filter circuitry, comprising: an input node configured to receive an input signal V_{IN} having a dominant frequency f_{PPF}; and a common-source amplifier circuit, wherein: the common-source amplifier circuit comprises a field-effect transistor M1 with its gate terminal connected to the input node and with a capacitor C_{PFF} connected to its source terminal; and for the common-source amplifier circuit, the output resistance R_{M1} seen at the source terminal of the field-effect transistor M1 and the capacitance of the capacitor C_{PFF} are configured to define the frequency response of the common-source amplifier circuit so that, based on the input signal V_{IN}, a signal V_{LEAD} is generated at the drain terminal of the transistor M1 which leads the input signal V_{IN} in phase by a given phase shift Δφ_{LEAD} and a signal V_{LAG} is generated at the source terminal of the transistor M1 which lags the input signal V_{IN} in phase by a given phase shift Δφ_{LAG}.

## Description

The present invention relates to filter circuitry, including circuitry thereof, and circuitry comprising the same. Such filter circuitry may comprise source-follower and/or common-source amplifier circuitry.

More specifically, the present disclosure relates to polyphase filter (Poly-Phase Filter, or PPF) circuitry, as an example filter type. PPF circuitry may be used to generate multiple output signals which have different relative phases based on one or more input signals. Such signals may be clock signals.

For example, as a running example, PPF circuitry may be used to generate a pair of clock signals (V_{LEAD}, V_{LAG}) which are 90° out of phase with one another (e.g. I and Q clock signals) based on an input clock signal V_{IN}. As another running example, PPF circuitry may be used to generate quadrature clock signals (V_{LEAD}, V_{LAG}, /V_{LEAD}, /V_{LAG}) which have relative phases 0°, 90°, 180° and 270°, respectively, and which may be referred to as I+, Q+, I- and Q- phases, respectively.

PPF circuitry may be used in clocked circuitry in general, for example in quadrature oscillator circuitry, phase lock loop circuitry (PLL), an analogue-to-digital converter (ADC), a digital-to-analogue converter (DAC), Serializer/Deserializer circuits (SERDES), Clock Data Recovery circuits (CDRs), Wireless Transceivers, Processors, IQ phase generation circuitry or clocking circuitry.

It has been found that the performance of previously-considered such circuitry is subject to considerable distortion, which is particularly exacerbated at high frequencies.

It is desirable to address such problems.

According to an embodiment of a first aspect of the present invention, there is provided polyphase filter circuitry, comprising: an input node configured to receive an input signal V_{IN} having a dominant frequency f_{PPF}; and a common-source amplifier circuit, wherein: the common-source amplifier circuit comprises a field-effect transistor M1 with its gate terminal connected to the input node and with a capacitor C_{PFF} connected to its source terminal; and for the common-source amplifier circuit, the output resistance R_{M1} seen at the source terminal of the field-effect transistor M1 and the capacitance of the capacitor C_{PFF} are configured to define the frequency response of the common-source amplifier circuit so that, based on the input signal V_{IN}, a signal V_{LEAD} is generated at the drain terminal of the transistor M1 which leads the input signal V_{IN} in phase by a given phase shift Δφ_{LEAD} and a signal V_{LAG} is generated at the source terminal of the transistor M1 which lags the input signal V_{IN} in phase by a given phase shift Δφ_{LAG}.

The signals V_{LEAD} and V_{LAG} of the common-source amplifier circuit may be output signals of the polyphase filter circuitry.

The polyphase filter circuitry may comprise first and second said common-source amplifier circuits, wherein the signal V_{LEAD} of the first common-source amplifier circuit and the signal V_{LAG} of the second common-source amplifier circuit are output signals of the polyphase filter circuitry.

The polyphase filter circuitry may further comprise a source-follower circuit, wherein: the source-follower circuit comprises a field-effect transistor M1 with its gate terminal connected to the input node and with a capacitor C_{PPF} connected to its source terminal; and for the source-follower circuit, the output resistance R_{M1} seen at the source terminal of the field-effect transistor M1 and the capacitance of the capacitor C_{PPF} are configured to define the frequency response of the source-follower circuit so that, based on the input signal V_{IN}, a signal V_{LAG} is generated at the source terminal of the transistor M1 which lags the input signal V_{IN} in phase by a given phase shift Δφ_{LAG}.

According to an embodiment of a second aspect of the present invention, there is provided polyphase filter circuitry, comprising: an input node configured to receive an input signal V_{IN} having a dominant frequency f_{PPF}; and first and second source-follower circuits, wherein: each source-follower circuit comprises a field-effect transistor M1 with its gate terminal connected to the input node and with a capacitor C_{PPF} connected to its source terminal; for each source-follower circuit, the output resistance R_{M1} seen at the source terminal of the field-effect transistor M1 and the capacitance of the capacitor C_{PPF} are configured to define the frequency response of the source-follower circuit so that, based on the input signal V_{IN}, a signal V_{LAG} is generated at the source terminal of the transistor M1 which lags the input signal V_{IN} in phase by a given phase shift Δφ_{LAG}; the given phase shifts Δφ_{LAG} for the first and second source-follower circuits are different from one another; and the signals V_{LAG} of the first and second source-follower circuits are output signals of the polyphase filter circuitry.

According to an embodiment of a third aspect of the present invention, there is provided multi-phase clock generation circuitry comprising: the polyphase filter circuitry of the aforementioned first or second aspect; and a source clock generation circuit configured to generate and provide to the polyphase filter circuitry the input signal V_{IN} as a source clock signal (or input signals V_{IN} and /V_{IN} as source clock signals - see the arrangements disclosed later herein), the output signals of the polyphase filter circuitry being output clock signals of the multi-phase clock generation circuitry having different relative phases from one another.

According to an embodiment of a fourth aspect of the present invention, there is provided clocked circuitry, comprising: the multi-phase clock generation circuitry of the aforementioned third aspect; and one or more clocked circuits connected to receive the output clock signals and operate based thereon.

According to an embodiment of a fifth aspect of the present invention, there is provided a source-follower circuit, comprising: an input node configured to receive an input signal V_{IN} having a dominant frequency f_{PPF}; a field-effect transistor M1 with its gate terminal connected to the input node; and a capacitor C_{PPF} connected to the source terminal of the field-effect transistor M1, wherein: the output resistance R_{M1} seen at the source terminal of the field-effect transistor M1 and the capacitance of the capacitor C_{PPF} are configured to define the frequency response of the source-follower circuit so that, based on the input signal V_{IN}, a signal V_{LAG} is generated at the source terminal of the transistor M1 which lags the input signal V_{IN} in phase by a given phase shift Δφ_{LAG}; the capacitor C_{PFF} is substantially directly connected between the source terminal of the field-effect transistor and a supply voltage node and is implemented as a MOS capacitor.

According to an embodiment of a sixth aspect of the present invention, there is provided a common-source amplifier circuit, comprising: the source-follower circuit of the aforementioned fifth aspect; and a resistor R_{DRAIN} connected between the drain terminal of the transistor and a supply voltage node, optionally wherein a signal V_{LEAD} is generated at the drain terminal of the transistor M1 which leads the input signal V_{IN} in phase by a given phase shift Δφ_{LEAD}.

According to an embodiment of a seventh aspect of the present invention, there is provided a source-follower circuit, comprising: an input node configured to receive an input signal V_{IN}; a field-effect transistor M1 with its gate terminal connected to the input node; and a capacitor C_{PPF} connected to the source terminal of the field-effect transistor M1, wherein: the capacitor C_{PFF} is substantially directly connected between the source terminal of the field-effect transistor and a supply voltage node and is implemented as a MOS capacitor.

According to an embodiment of an eighth aspect of the present invention, there is provided a common-source amplifier circuit, comprising: the source-follower circuit of the aforementioned seventh aspect; and a resistor R_{DRAIN} connected between the drain terminal of the transistor and a supply voltage node.

According to an embodiment of a ninth aspect of the present invention, there is provided integrated circuitry, such as an IC chip, comprising the polyphase filter circuitry of the aforementioned first or second aspect, or the multi-phase clock generation circuitry of the aforementioned third aspect, or the clocked circuitry of the aforementioned fourth aspect, or the source-follower circuit or common-source amplifier circuit of any of the aforementioned fifth to eighth aspects.

Also envisaged are corresponding method aspects. Preferred features of one aspect may be applied to another aspect, and *vice versa.*

Reference will now be made, by way of example, to the accompanying drawings, of which:
Figure 1 is a schematic diagram of previously-considered PPF circuitry;
Figure 2 is a schematic diagram of an equivalent circuit of the PPF circuitry of Figure 1;
Figures 3 to 8 present schematic diagrams of PPF circuitry embodying the present invention;
Figures 9 and 10 are each schematic diagrams of clocked circuitry and multi-phase clock generation circuitry embodying the present invention;
Figure 11 presents a graphical output of simulation results based on a simulation of multi-phase clock generation circuitry; and
Figure 12 is a schematic diagram of integrated circuitry embodying the present invention.

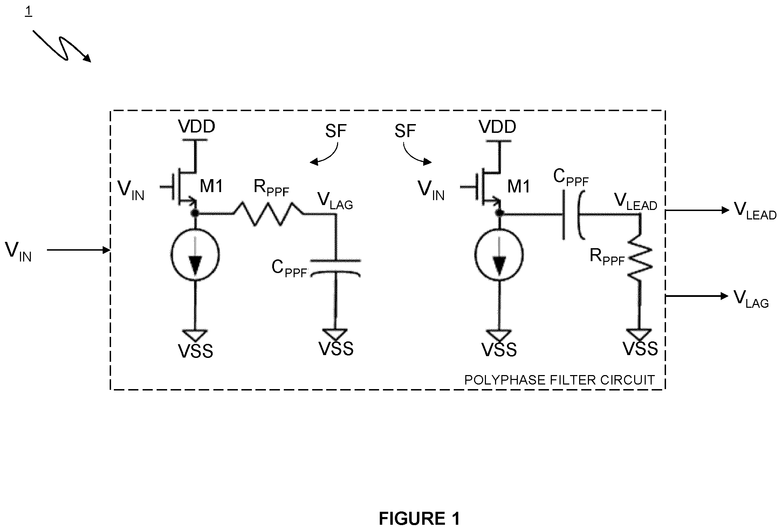

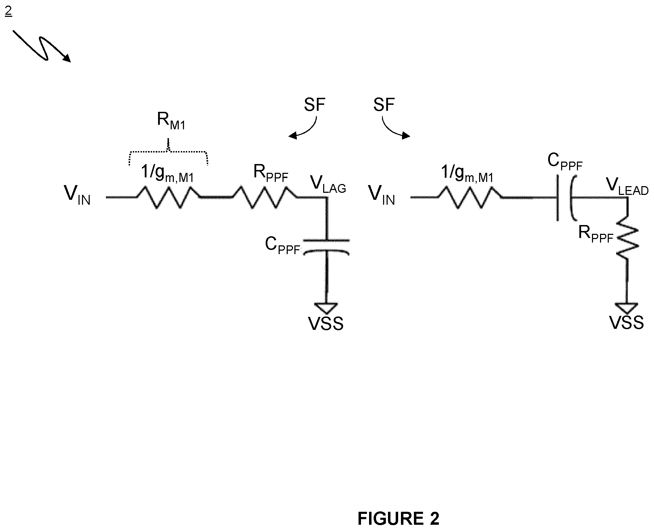

In order to better appreciate problems with previously-considered filter circuitry, reference will be made to Figures 1 and 2.

**Figure 1** is a schematic diagram of previously-considered PPF circuitry 1. PPF circuitry 1 comprises a pair of RC filter circuits and an input node configured to receive an input (voltage) signal V_{IN} having a dominant frequency (or peak frequency or tone frequency) f_{PPF}. The input signal V_{IN} may for example be a sinusoidal signal.

Both of the RC filter circuits are source-follower (SF) circuits as indicated. The left-hand SF circuit is configured as a low-pass filter and the right-hand SF circuit is configured as a high-pass filter circuit.

In detail, the left-hand SF circuit comprises a field-effect transistor M1 with its gate terminal connected to the input node, with its drain terminal connected to a first supply voltage node (here, VDD or AVD) and with its source terminal connected to a second supply voltage node (here, VSS or AVS, effectively GND or ground) via a current source. The voltages at the first and second supply voltage nodes may be considered high and low voltages, or first and second different voltages, respectively. The transistor M1 is an N-channel MOSFET (Metal-Oxide-Semiconductor Field-Effect Transistor). The source terminal of the field-effect transistor M1 is also connected to the second supply voltage node via a resistor R_{PPF} and a capacitor C_{PPF} connected in series in that order.

The right-hand SF circuit is configured in the same way as the left-hand SF circuit except that its resistor R_{PPF} and capacitor C_{PPF} are connected in series in the opposite order so as to enable a high-pass function rather than a low-pass function.

The SF arrangement supplies isolation between the PPF circuitry 1 and a driver circuit (not shown - providing the input signal V_{IN}), for example a tuned LC-buffer, to avoid resistive/capacitive loading by the PPF circuitry 1 on the driver circuit. That is, the SF arrangement acts as a buffer to minimize or reduce loading on preceding stages.

As a running example, it will be assumed that the left-hand SF circuit is configured as an RC low-pass filter circuit with pole cut-off frequency equal to the frequency of operation f_{PPF} to create a 45° lagging (voltage) signal V_{LAG} at a node between the resistor R_{PPF} and capacitor C_{PPF} as indicated, with 0.707 (√2) attenuation. Similarly, it will be assumed that the right-hand SF circuit is configured as an RC high-pass filter circuit with a zero at the origin and a pole at the frequency of operation f_{PPF} to create a 45° leading (voltage) signal V_{LEAD} at a node between the capacitor C_{PPF} and resistor R_{PPF} as indicated, also with 0.707 (√2) attenuation.

The nodes at which the signals V_{LAG} and V_{LEAD} are generated may be considered output nodes of the PPF circuitry 1, and those signals may similarly be referred to as output signals of the PPF circuitry 1.

**Figure 2** is a schematic diagram of an equivalent circuit 2 of the PPF circuitry 1.

Equivalent circuit 2 comprise a pair of equivalent circuits or sub-circuits, one for each of the SF circuits of Figure 1 as indicated. The left-hand equivalent circuit represents the low-pass filter and the right-hand equivalent circuit represents the high-pass filter.

In detail, looking at the left-hand equivalent circuit (corresponding to the left-hand SF circuit of Figure 1), the SF has an equivalent output resistance of 1/g_{m,M1}, where g_{m,M1} is the transconductance of the transistor M1, which appears as a series resistance at the input node where the input signal V_{IN} is received. This equivalent output resistance 1/g_{m,M1} may be referred to as the output resistance R_{M1} seen at the source terminal of the transistor M 1. This resistance R_{M1} is therefore shown in series with the resistor R_{PPF} and capacitor C_{PPF} in line with the left-hand SF circuit of Figure 1.

The resistance R_{M1} has the effect of shifting the filter pole. For the resistance R_{M1} to have a negligible effect on pole location, 1/g_{m,M1} typically needs to be at least ten times smaller than the resistance of R_{PPF}, or the presence of the resistance R_{M1} needs to be designed into the value of R_{PPF}. The transconductance g_{m,M1} cannot be increased arbitrarily without loading the driver stage, which places a lower-limit on the resistance of R_{PPF}. Consequently, the capacitance of the capacitor C_{PPF} has an upper limit to keep the same pole location.

Similar analysis, taking into account 1/g_{m,M1}, may be applied to the right-hand equivalent circuit (corresponding to the right-hand SF circuit of Figure 1).

Looking at Figures 1 and 2, the PPF circuitry 1 has been found to suffer from large amplitude and/or phase variation across process corners. This variation may in part be due to non-linearities and PVT variations.

A process corner here may be taken as an example of a "design-of-experiments" technique, known in semiconductor manufacturing, that refers to a variation of fabrication parameters used in applying an integrated circuit design to a semiconductor wafer. Process corners represent the extremes of these parameter variations within which a circuit that has been etched onto the wafer must function correctly. A circuit employing devices fabricated at these process corners may run slower or faster than specified and at lower or higher temperatures and voltages, or may not function at all (and be considered to have inadequate design margin).

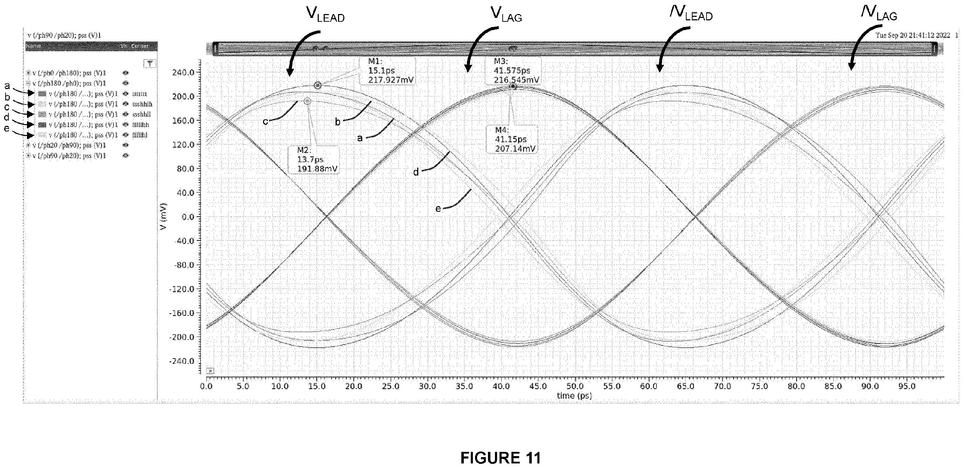

Taking field-effect transistors as an example, one naming convention for process corners (adopted in Figure 11 described later herein) is to use two-letter designators, where the first letter refers to the N-channel MOSFET (NMOS) corner, and the second letter refers to the P channel (PMOS) corner. In this naming convention, three corners exist: typical (t), fast (f) and slow (s). Fast and slow corners exhibit carrier mobilities that are higher and lower than normal, respectively. For example, a corner designated as fs denotes fast N-channel MOSFETs and slow P-channel MOSFETs. There are therefore five possible corners: typical-typical (tt), fast-fast (ff), slow-slow (ss), fast-slow (fs), and slow-fast (sf). Corners may also be defined in terms of temperature: low (l) and high (h).

The main reason for the large spread in amplitude and/or phase across process corners is the pole frequency location which depends heavily on the resistor R_{PPF} and capacitor C_{PPF} process corners, which are normally uncorrelated. The low value of the capacitance of the capacitor C_{PPF} in the PPF circuit 1 as mentioned earlier also makes the PPF circuit 1 sensitive to loading capacitance of the succeeding stage, resulting in more spread across corners.

The arrangements disclosed herein seek to address such problems by configuring the PPF circuitry, and its constituent filter circuits, to reduce the number of different types of device (transistors, capacitors, resistors) required, as will become apparent. In some arrangements, both the capacitors and resistors are implemented using the same device type, which results in tracking across process deviation and much lower process deviation spread in comparison with the PPF circuitry 1. The arrangements disclosed herein significantly reduce the effect of process corner variation on PPF performance.

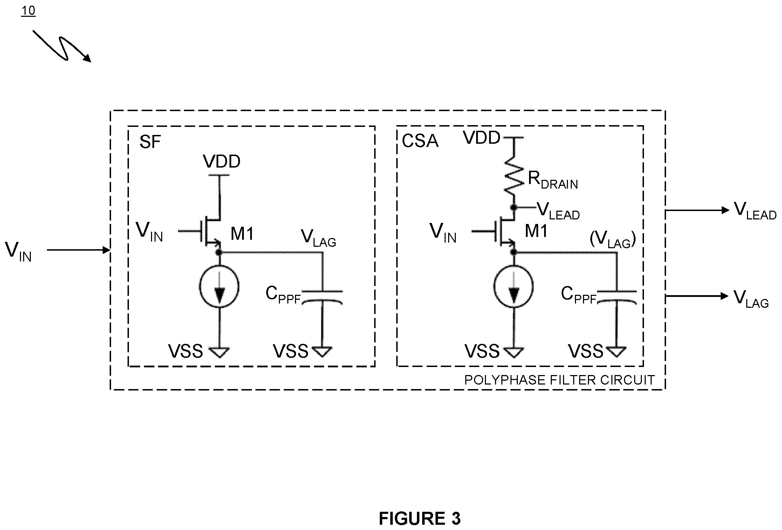

**Figure 3** is a schematic diagram of PPF circuitry 10 embodying the present invention.

PPF circuitry 10 comprises a pair of RC filter circuits (or circuits which may have RC filter circuits as equivalent circuits), shown in separate dashed boxes, and an input node configured to receive an input signal V_{IN} having a dominant frequency (or peak frequency or tone frequency) f_{PPF}. The terminology "RC filter" will be used herein for ease of explanation, understanding that the disclosed circuits function as RC filter circuits (in the sense of an RC circuit configured with discrete R and C components being an equivalent circuit), even when the R component of the RC filter function is not implemented by a discrete/passive resistor as such. The present disclosure will be understood accordingly.

One of the RC filter circuits is a source-follower (SF) circuit, as indicated, and the other of the RC filter circuits is a source-degenerated common-source amplifier (CSA) circuit, also as indicated. The left-hand SF circuit is configured as (or to act as) a low-pass filter and the right-hand CSA circuit is configured as (or to act as) a low-pass filter and/or a high-pass filter depending on where the output signal is taken from. The source-degenerated common-source amplifier circuit will be referred to herein as a common-source amplifier (CSA) circuit for simplicity.

The left-hand SF circuit is similar to the left-hand SF circuit in Figure 1, except that the resistor R_{PPF} has been omitted (the resistance of the RC filter function coming from the output resistance as seen at the source terminal of the transistor M1). In detail, the left-hand SF circuit in Figure 3 comprises a field-effect transistor M1 with its gate terminal connected to the input node, with its drain terminal connected to a first supply voltage node (here, VDD or AVD as before) and with its source terminal connected to a second supply voltage node (here, VSS or AVS as before) via a current source. In some arrangements the current source may be replaced with a resistor. The source terminal of the field-effect transistor M1 is also connected (directly, i.e. without a series-connected discrete resistor) to the second supply voltage node via a capacitor C_{PPF}. In practice, a (small) resistor may be connected in series with the capacitor C_{PPF} as long as its effect on pole location is negligible for a given application.

The right-hand CSA circuit is configured in the same way as the left-hand SF circuit except that the drain terminal of the transistor M1 is connected to the first supply voltage node via a resistor R_{DRAIN}, thus forming the CSA arrangement. In the arrangement shown, the drain terminal of the transistor M1 is connected to the first supply voltage node substantially directly via the resistor R_{DRAIN}.

As before, the SF and CSA arrangements supply isolation between the PPF circuitry 10 and a driver circuit (not shown), i.e. minimizing or reducing loading on preceding stages.

Continuing the running example, it will be assumed that the left-hand SF circuit is configured as an RC low-pass filter with pole cut-off frequency equal to the frequency of operation f_{PPF} to create a 45° lagging signal V_{LAG} at the source terminal of the transistor M1 as indicated, with 0.707 (√2) attenuation. Similarly, it will be assumed that the right-hand CSA circuit is configured to provide an RC high-pass filter function with a zero at the origin and a pole at the frequency of operation f_{PPF} to create a 45° leading signal V_{LEAD} at the drain terminal of the transistor M1 also as indicated, also with 0.707 (√2) attenuation.

The arrangement of Figure 3 relaxes the upper limit for C_{PPF}.

To generate the V_{LAG} signal, the left-hand SF circuit employs the source-follower output resistance R_{M1} to create the low-pass filter function along with the capacitor C_{PPF}. The pole frequency=g_{m,M1},/(2*π*C_{PPF}) is set to be equal to the operation frequency f_{PPF}. Here, for simplicity, C_{PPF} represents the capacitance of the capacitor C_{PPF}, and similarly R_{DRAIN} will be used to represent the resistance of the resistor R_{DRAIN}.

To generate the V_{LEAD} signal, the right-hand CSA circuit employs source degeneration to create a zero at DC (or very low frequency) and a pole at g_{m,M1}/(2*π*C_{PPF}).

As a result, the C_{PPF} value can be much higher.

As also indicated in Figure 3, the V_{LAG} signal is also available at the source terminal of the transistor M1 of the right-hand CSA circuit, based on a low-pass filter function to that node. In situations where there is minimal or negligible capacitive loading at the drain terminal of the transistor M1 of the right-hand CSA circuit, or if the phase requirements are suitable, the V_{LEAD} and V_{LAG} signals may both be taken from the right-hand CSA circuit, and the left-hand SF circuit may then be omitted. If there is significant capacitive loading at the drain terminal of the transistor M1, it may be that only the V_{LEAD} signal is used and the V_{LAG} signal is unused (and hence it is shown in parentheses).

Thus, as indicated in Figure 3, the V_{LAG} and V_{LEAD} signals from the left-hand SF circuit and right-hand CSA circuit of the PPF circuit 10, respectively, may form output signals of the PFF circuit 10 at corresponding output nodes. In another arrangement, the V_{LAG} and V_{LEAD} signals from the right-hand CSA circuit of the PPF circuit 10 may form output signals of the PFF circuit 10 (and the left-hand SF circuit may be omitted).

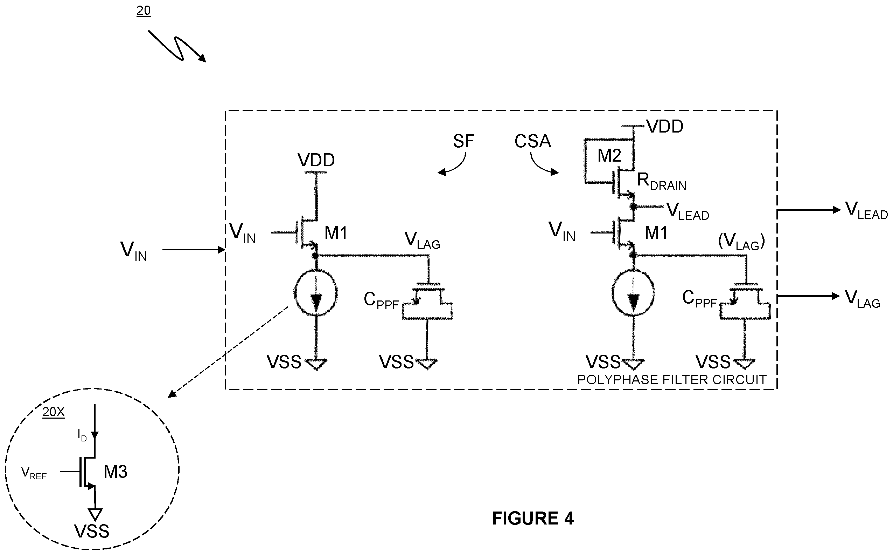

**Figure 4** is a schematic diagram of PPF circuitry 20 embodying the present invention, which may be considered a development of the PPF circuitry 10.

PPF circuitry 20, like the PPF circuitry 10, comprises a pair of RC filter circuits (here not shown in separate dashed boxes), one of which is a source-follower (SF) circuit as indicated and the other of which is a source-degenerated common-source amplifier (CSA) circuit as indicated, and an input node configured to receive the input signal V_{IN} having a dominant frequency (or peak frequency or tone frequency) f_{PPF}. It is recalled that these circuits are referred to as "RC filter" circuits in terms of their function, as here the R element of the RC filter is not implemented by a discrete/passive resistance. The circuits could be referred to simply as filter circuits, for example.

The left-hand SF circuit and the right-hand CSA circuit of Figure 4 are the same as the left-hand SF circuit and the right-hand CSA circuit of Figure 3, respectively, except that the capacitors C_{PPF} are implemented as MOS capacitors, in this example as field-effect transistors configured as MOS capacitors.

The PPF circuitry 20 exploits the fact that the poles for the left-hand SF circuit and the right-hand CSA circuit are defined by the output resistance 1/g_{m,M1}, or R_{M1}, as mentioned earlier. In the PPF circuitry 20 each capacitor C_{PPF} is implemented as an NMOS field-effect transistor configured as MOS capacitor. For fast process corners, the transconductance of M1, i.e. g_{m,M1}, is higher, resulting into lower output resistance R_{M1} and higher C_{PPF} active capacitance, and *vice versa* for slow process corners. Consequently, the pole frequency spread across process corners is reduced.

In the right-hand CSA circuit (common-source stage), the resistor R_{DRAIN} is also implemented as a field-effect transistor, in this case as a diode-connected NMOS field-effect transistor M2. The diode-connected transistor M2 is connected in series (i.e. with its channel in series) between the drain terminal of the transistor M1 of the right-hand CSA circuit and the first supply voltage node (here, VDD), substantially directly.

In an example variation 20X shown in a dashed circle, the current sources may also be implemented as a field-effect transistor, in this case as an NMOS field-effect transistor M3 whose gate voltage is controlled by a reference voltage V_{REF} to control the drain current I_{D}. Although only explicitly shown in respect of the left-hand SF circuit in Figure 4, this applies equally to all of the current sources of the circuits described herein. The variation 20X is one example implementation of a current source using a field-effect transistor; other example implementations (not shown) may be employed such as a field-effect transistor in series with a resistor (which resistor could be implemented as a field-effect transistor, such as a diode-connected field-effect transistor). As another variation (not shown), the current sources may be replaced with resistors, which again could each be implemented as a field-effect transistor, such as a diode-connected field-effect transistor. The present disclosure will be understood accordingly.

In the implementation of Figure 4, taking into account variation 20X, all of the discrete components are implemented with field-effect transistors, in this case NMOS field-effect transistors.

The gain of the signal V_{LEAD} in the right-hand CSA circuit (common-source stage) is g_{m,M1}/g_{m,M2}, where g_{m,M2} is the transconductance of the transistor M2, which has low spread across corners if the M1 and M2 devices are of the same or similar type and/or of the same semiconductor fabrication process and/or have the same or similar fabrication parameters. For example, where devices M1 and M2 are of the same fabrication process, their fabrication parameters and masks may be the same as in mass production of a product. Of course, all fabrication processes have uncontrollable variations, which lead to circuit variation on different chips but much less variation of transistors/devices in close proximity.

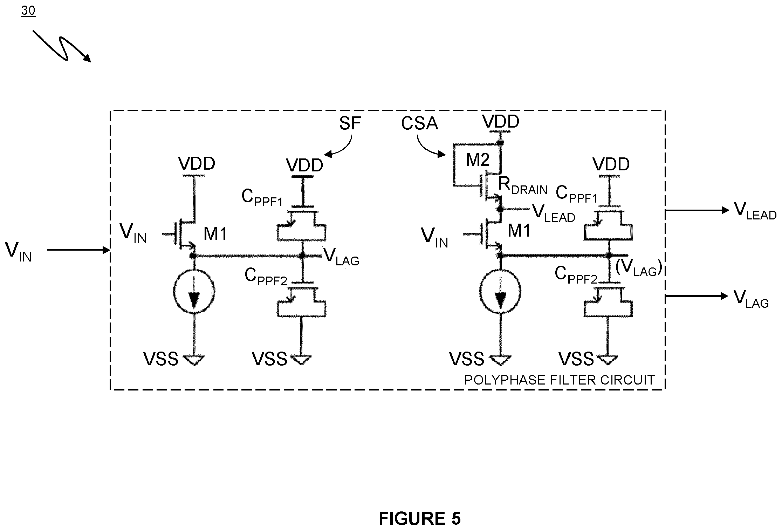

**Figure 5** is a schematic diagram of PPF circuitry 30 embodying the present invention, which may be considered a development of the PPF circuitry 20.

PPF circuitry 30, like the PPF circuitry 10 and 20, comprises a pair of "RC filter" circuits (again, not shown in separate dashed boxes), one of which is a source-follower (SF) circuit as indicated and the other of which is a source-degenerated common-source amplifier (CSA) circuit as indicated, and an input node configured to receive the input signal V_{IN} having a dominant frequency f_{PPF}.

The left-hand SF circuit and the right-hand CSA circuit of Figure 5 are the same as the left-hand SF circuit and the right-hand CSA circuit of Figure 4, respectively, except that the capacitors C_{PPF} are each implemented as a pair of MOS capacitors, C_{PPF1} and C_{PPF2}.

The capacitors C_{PPF1} and C_{PPF2} are implemented as field-effect transistors, here NMOS transistors, configured as MOS capacitors. For each circuit, C_{PPF1} is connected between the source terminal of the transistor M1 and the first supply voltage node (here, VDD), substantially directly, and C_{PPF2} is connected between the source terminal of the transistor M1 and the second supply voltage node (here, VSS), again substantially directly.

The capacitors C_{PPF1} and C_{PPF2} may have substantially the same capacitance as one another, effectively dividing the capacitor C_{PPF} into two halves. By dividing the capacitor C_{PPF} into two halves, one connected to the first supply voltage node and the other connected to the second supply voltage node, performance is further improved. Using this technique, the C_{PPF} MOS capacitor variation in capacitor versus the voltage swing which would be experienced in Figure 4 is reduced in Figure 5. By way of explanation, as V_{LAG} increases, the C_{PPF1} capacitance decreases, whereas the C_{PPF2} capacitance increases, and *vice versa* for V_{LAG} decrease.

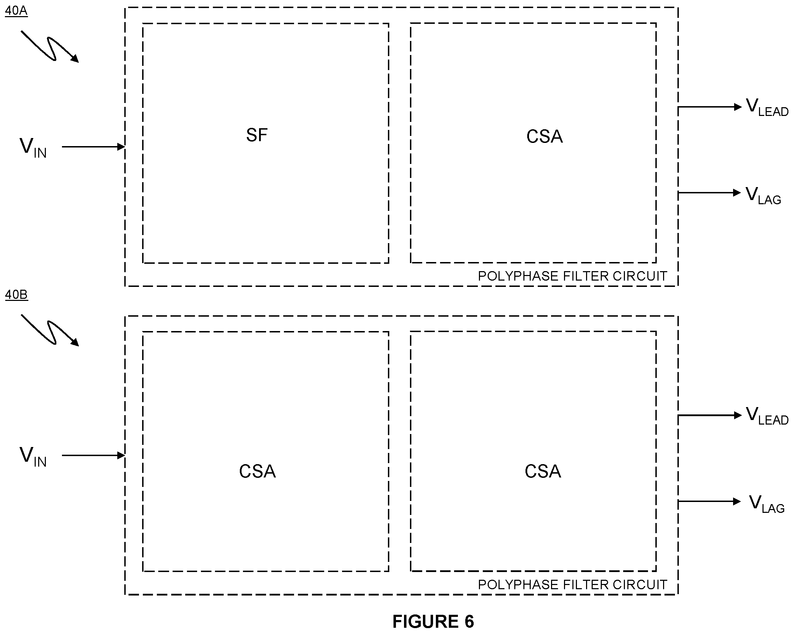

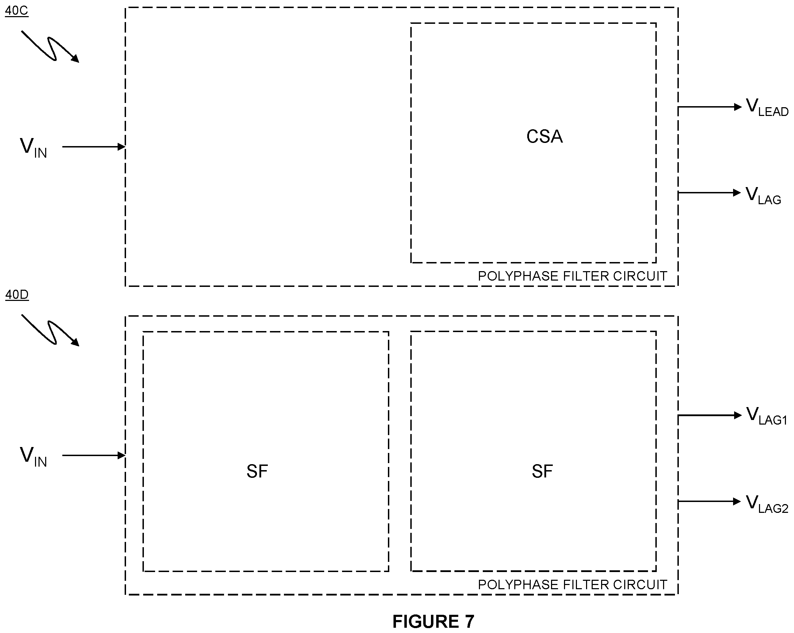

As will be appreciated, various implementations of PPFs are envisaged which may output a plurality of output signals having different relative phases (e.g. V_{LAG}, V_{LEAD}) based on an input signal (e.g. V_{IN}). **Figures 6** **and** **7** present schematic views of PPF circuitry 40A, 40B, 40C, and 40D to give examples of such different arrangements of PPF circuitry.

PPF circuitry 40A may be understood to generate output signals V_{LAG} and V_{LEAD} based on the input signal V_{IN}, and to comprise a SF circuit and a CSA circuit. PPF circuitry 40A may therefore be the same as any of PFF circuitry 10, 20 and 30, where the output signal V_{LAG} is, or is derived from, the signal V_{LAG} of the left-hand SF circuit, and where the output signal V_{LEAD} is, or is derived from, the signal V_{LEAD} of the right-hand CSA circuit.

PPF circuitry 40B may be understood to generate output signals V_{LAG} and V_{LEAD} based on the input signal V_{IN}, and to comprise two CSA circuits. Each CSA circuit of the PPF circuitry 40B may therefore be the same as the CSA circuit of any of PFF circuitry 10, 20 and 30. That is, the CSA circuits of the PPF circuitry 40B may both be the same as the CSA circuit of the same PPF circuitry of PFF circuitry 10, 20 and 30, or may be the same as the CSA circuits from respective different PPF circuitry of PFF circuitry 10, 20 and 30. In the PPF circuitry 40B, the output signal V_{LAG} is, or is derived from, the signal V_{LAG} of the left-hand CSA circuit, and the output signal V_{LEAD} is, or is derived from, the signal V_{LEAD} of the right-hand CSA circuit.

PPF circuitry 40C may be understood to generate output signals V_{LAG} and V_{LEAD} based on the input signal V_{IN}, and to comprise (only) one CSA circuit. The CSA circuit of the PPF circuitry 40C may be the same as the CSA circuit of any of PFF circuitry 10, 20 and 30. In the PPF circuitry 40C, the output signals V_{LAG} and V_{LEAD} are, or are derived from, the signals V_{LAG} and V_{LEAD} of the same CSA circuit. As mentioned earlier, this arrangement may be suitable where there is negligible capacitive loading.

PPF circuitry 40D may be understood to generate output signals V_{LAG1} and V_{LAG2} (which may be compared to output signals V_{LAG} and V_{LEAD} in that they have different relative phases) based on the input signal V_{IN}, and to comprise two SF circuits. Each SF circuit of the PPF circuitry 40D may therefore be the same as the SF circuit of any of PFF circuitry 10, 20 and 30. That is, the SF circuits of the PPF circuitry 40D may both be the same as the SF circuit of the same PPF circuitry of PFF circuitry 10, 20 and 30, or may be the same as the SF circuits from respective different PPF circuitry of PFF circuitry 10, 20 and 30. In the PPF circuitry 40D, the output signal V_{LAG1} is, or is derived from, the signal V_{LAG} of the left-hand SF circuit, and the output signal V_{LAG2} is, or is derived from, the signal V_{LAG} of the right-hand SF circuit. In order to generate output signals V_{LAG1} and V_{LAG2} with different relative phases, the resistance R_{M1} and/or capacitance C_{PPF} (or C_{PPF1} in combination with C_{PPF2}) may be configured differently between the two SF circuits as would be understood by the skilled person. References to circuits generating output signals V_{LAG} and V_{LEAD} may therefore be considered to also apply to circuits generating output signals V_{LAG1} and V_{LAG2}, where PPF circuitry 40D is involved, and the present disclosure will be understood accordingly.

The PFF circuitry considered above focuses on outputting a plurality of output signals having different relative phases (e.g. V_{LAG}, V_{LEAD}) based on a single input signal (e.g. V_{IN}). For example, where the given phase shifts are 45° phase shifts as in the running example, the output signals V_{LAG}, V_{LEAD} may have relative phases 0° and 90° and be referred to as I and Q phases, respectively. Multiple sets of such PPF circuitry could however be provided to operate based on different such input signals.

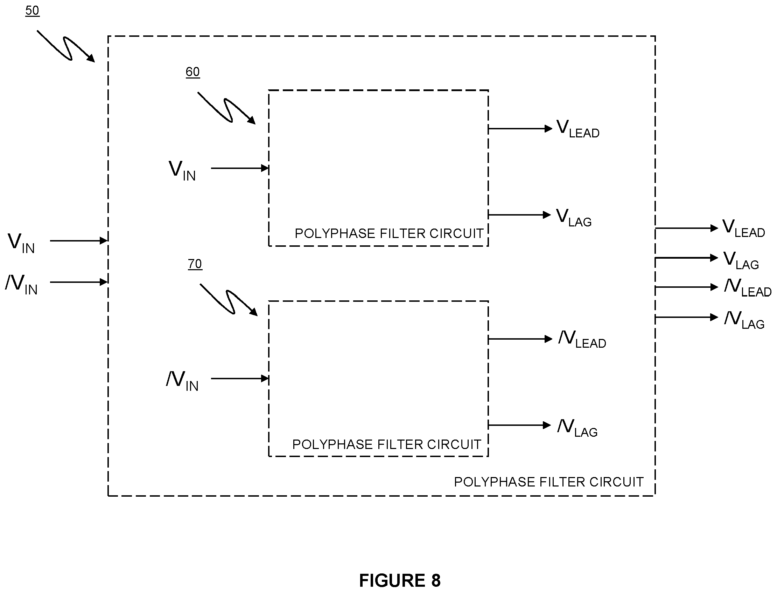

**Figure 8** is a schematic diagram of PPF circuitry 50 embodying the present invention. PPF circuitry 50 comprises two sets of PPF circuitry 60 and 70.

The PPF circuitry 60 may be taken to be the same as any of the PPF circuitry 10, 20, 30, 40A, 40B, 40C, 40D described above, and thus comprises an input node configured to receive the input signal V_{IN} and to output output signals V_{LAG} and V_{LEAD}.

The PPF circuitry 70 may also be taken to be the same as any of the PPF circuitry 10, 20, 30, 40A, 40B, 40C, 40D described above, except that it is connected to receive an input signal /V_{IN} rather than the input signal V_{IN}, wherein V_{IN} and /V_{IN} are complementary signals. The PPF circuitry 70 therefore outputs signals /V_{LAG} and /V_{LEAD} instead of signals V_{LAG} and V_{LEAD}, respectively, where signals /V_{LAG} and /V_{LEAD} may be considered complementary signals of signals V_{LAG} and V_{LEAD}, respectively.

Overall, therefore, the PPF circuitry 50 may be considered to have first and second input nodes for receiving input signals V_{IN} and /V_{IN}, respectively, and to output output signals V_{LAG}, V_{LEAD}, /V_{LAG} and /V_{LEAD}. Where V_{IN} and /V_{IN} are complementary signals (i.e. 180° out of phase), and where the phase shifts created in the PPF circuitry 60 and PPF circuitry 70 are all for example 45° as in the running example, the output signals V_{LAG}, V_{LEAD}, /V_{LAG} and /V_{LEAD} may constitute a set of quadrature output signals, which may have relative phases 0°, 90°, 180° and 270°, respectively, and which may be referred to as I+, Q+, I- and Q- phases, respectively. In such a case, the PPF circuitry 50 may be, or be part of, quadrature oscillator circuitry.

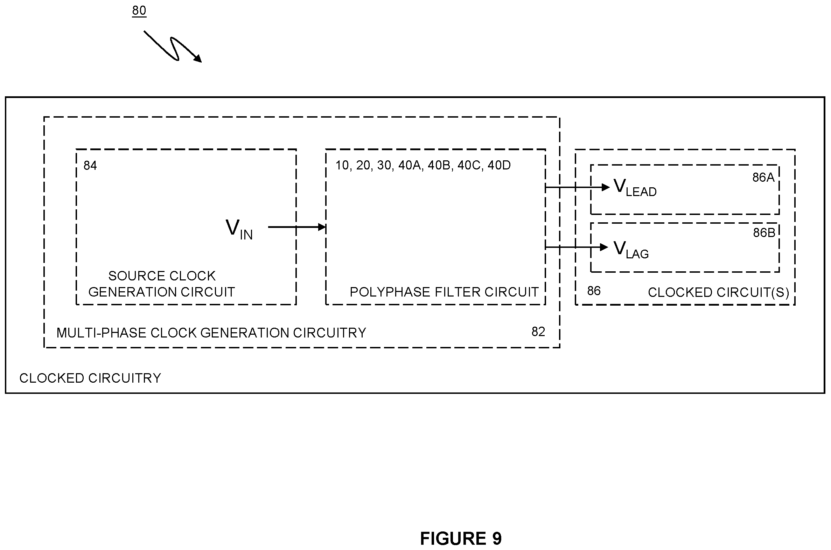

**Figure 9** is a schematic diagram of clocked circuitry 80 embodying the present invention, comprising multi-phase clock generation circuitry 82 also embodying the present invention. Clock signals herein may be considered oscillator signals.

The multi-phase clock generation circuitry 82 may be considered to comprise any of the PPF circuitry 10, 20, 30, 40A, 40B, 40C, 40D described above, and a source clock generation circuit 84 configured to generate and provide to the polyphase filter circuitry the input signal V_{IN} as a source clock signal. The output signals of the polyphase filter circuitry are then the output clock signals of the multi-phase clock generation circuitry 82 and have different relative phases from one another.

The clocked circuitry 80 comprises the multi-phase clock generation circuitry 82 and one or more clocked circuits 86 connected to receive the output clock signals of the polyphase filter circuitry and to operate based thereon. For ease of understanding, individual clocked circuits 86A and 86B operating based on the output signals V_{LAG} and V_{LEAD}, respectively, are shown. However, in general one or more clocked circuits 86 may be connected to receive the output clock signals.

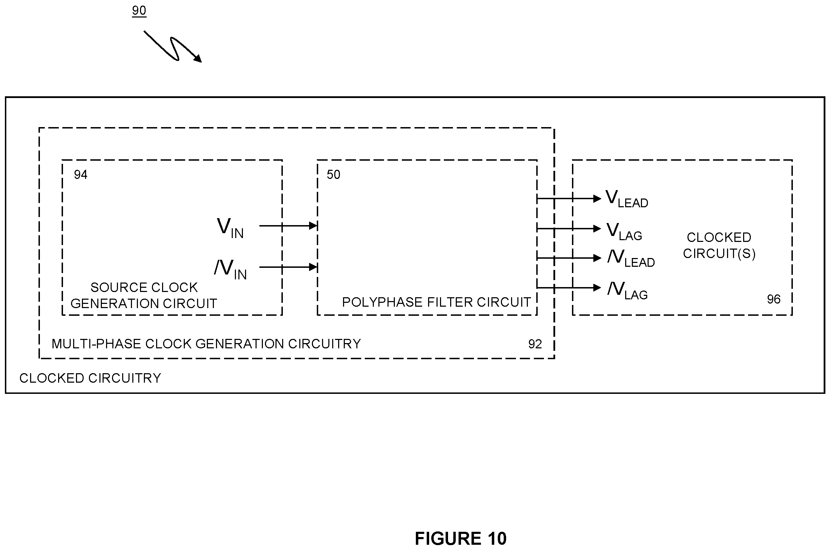

**Figure 10** is a schematic diagram of clocked circuitry 90 embodying the present invention, comprising multi-phase clock generation circuitry 92 also embodying the present invention.

The multi-phase clock generation circuitry 92 may be considered to comprise the PPF circuitry 50 described above, and a source clock generation circuit 94 configured to generate and provide to the polyphase filter circuitry the input signals V_{IN} and /V_{IN} as source clock signals. The output signals of the polyphase filter circuitry 50 are then the output clock signals of the multi-phase clock generation circuitry 92 and have different relative phases from one another.

The clocked circuitry 90 comprises the multi-phase clock generation circuitry 92 and one or more clocked circuits 96 connected to receive the output clock signals of the polyphase filter circuitry 50 and to operate based thereon.

The clocked circuitry 80 or 90, or the multi-phase clock generation circuitry 82 or 92, may be or be part of quadrature oscillator circuitry, phase lock loop circuitry (PLL), an analogue-to-digital converter (ADC), a digital-to-analogue converter (DAC), Serializer/Deserializer circuits (SERDES), Clock Data Recovery circuits (CDRs), Wireless Transceivers, Processors, IQ phase generation circuitry or clocking circuitry.

**Figure 11** presents a graphical output of simulation results based on a simulation of the multi-phase clock generation circuitry 92 (see Figure 10), where the PPF circuitry 60 and the PPF circuitry 70 of the PPF circuitry 50 (see Figure 8) are each the same as the PPF circuitry 30 (see Figure 5). Also, for each instance of the PPF circuitry 30, the output signal V_{LEAD} (or /V_{LEAD}) is generated by the CSA circuit and the output signal V_{LAG} (or /V_{LAG}) is generated by the SF circuit.

The graph shows the simulation of the output signals V_{LAG}, V_{LEAD}, /V_{LAG} and /V_{LEAD} across process corners (see the lefthand panel), in this case (for the transistors) typical-typical (tt), slow-slow (ss), and fast-fast (ff), as mentioned earlier. Temperature corners are also taken into account, giving traces for V_{LEAD} in the order as in the left-hand panel for tt room temperature (tt*t), ss high temperature (ss*h), ss low temperature (ss*l), ff high temperature (ff*h) and ff low temperature (ff*l), where tt*t corresponds to trace ttttttt whose label starts with tt and ends with t (the intermediate letters being ignored for these purposes). These traces for V_{LEAD} are labelled a to e, respectively, and are those whose peaks align with the label V_{LEAD} above the graph. Corresponding traces are also provided for V_{LAG}, /V_{LEAD} and /V_{LAG} but are not listed specifically in the lefthand panel. The labels M1, M2, M3 and M4 in Figure 11 are markers marking four readings to indicate the spread, and do not correspond to the reference signs M1 and M2 for transistors in the earlier Figures.

As can be seen, the spread across process and temperature is relatively low, and is lower for V_{LAG} and /V_{LAG} than for V_{LEAD} and /V_{LEAD}. This is because the resistance R_{DRAIN} (see Figure 5) affects the gain of V_{LEAD} and /V_{LEAD} and the signals V_{LAG} and /V_{LAG} do not have this additional factor. The reason for the spread is the extra parasitic capacitance at the V_{LEAD} node which creates an extra parasitic pole that can slightly shift the V_{LEAD} signal. The extra pole is not present for the V_{LAG} signal. Overall, the multi-phase clock generation circuitry 92 exhibits minimal spread across process and temperature.

It will be appreciated the circuitry disclosed herein enables implementation of PPF with reduced phase/amplitude spread across process corners to improve overall system performance. It will also be appreciated that the component RC filter circuits of the PPF circuitry disclosed herein contribute to the PPF performance. Accordingly, the present invention extends to the SF or CSA circuits individually (or combinations thereof) of PPF circuitry 10, 20 and 30.

For example, looking at Figures 5 to 7, there is provided a source-follower circuit, comprising: an input node configured to receive the input signal V_{IN} having a dominant frequency f_{PPF}; a field-effect transistor M1 with its gate terminal connected to the input node; and a capacitor C_{PPF} connected to the source terminal of the field-effect transistor M1, wherein: the output resistance R_{M1} seen at the source terminal of the field-effect transistor M1 and the capacitance of the capacitor C_{PPF} are configured to define the frequency response of the source-follower circuit so that, based on the input signal V_{IN}, a signal V_{LAG} is generated at the source terminal of the transistor M1 which lags the input signal VIN in phase by a given phase shift Δφ_{LAG}. The capacitor C_{PFF} may be substantially directly connected between the source terminal of the field-effect transistor and a supply voltage node and be implemented as a MOS capacitor (e.g. as a field-effect transistor configured as the MOS capacitor). The capacitor C_{PFF} may be implemented as a capacitor C_{PPF1} and a capacitor C_{PPF2} as described earlier. Similarly, there is provided a common-source amplifier circuit, comprising: the source-follower circuit, and a resistor R_{DRAIN} (which may be a diode-connected field-effect transistor) connected between the drain terminal of the transistor and a supply voltage node. A signal V_{LEAD} may be generated at the drain terminal of the transistor M1 which leads the input signal V_{IN} in phase by a given phase shift Δφ_{LEAD}. The field-effect transistors may be of the same or similar type and/or of the same semiconductor fabrication process.

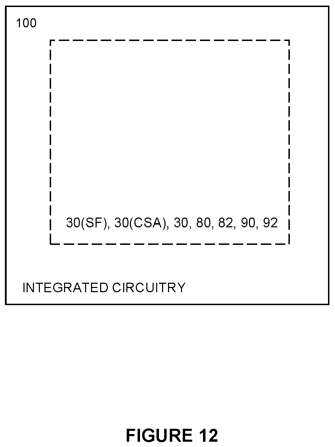

Any of the circuitry disclosed herein may be implemented as integrated circuitry or as an integrated circuit, for example as (or as part of) and IC chip, such as a flip chip. **Figure 12** is a schematic diagram of integrated circuitry 100 embodying the present invention. The integrated circuitry 100 may comprise any of the PPF circuitry (such as PPF circuitry 10, 20, 30, 40A, 40B, 40C, 40D, 50), indicated as PPF circuitry 30 in Figure 12 for simplicity, the SF or CSA circuits thereof (indicated as 30(SF), 30(CSA) in Figure 12 for simplicity, or the multi-phase clock generation circuitry 82 or 92, or the clocked circuitry 80 or 90.

Integrated circuitry 100 may be representative of some or all of an IC chip. The present invention extends to integrated circuitry and IC chips as mentioned above, circuit boards comprising such IC chips, and communication networks (for example, internet fiber-optic networks and wireless networks) and network equipment of such networks, comprising such circuit boards.

The present invention may be embodied in many different ways in the light of the above disclosure, within the spirit and scope of the appended claims.

The present disclosure extends to the following statements:
A1. Polyphase filter circuitry, comprising:
   an input node configured to receive an input signal V_{IN} having a dominant frequency f_{PPF}; and
   a common-source amplifier circuit,
   wherein:
      the common-source amplifier circuit comprises a field-effect transistor M1 with its gate terminal connected to the input node and with a capacitor C_{PFF} connected to its source terminal; and
      for the common-source amplifier circuit, the output resistance R_{M1} seen at the source terminal of the field-effect transistor M1 and the capacitance of the capacitor C_{PFF} are configured to define the frequency response of the common-source amplifier circuit so that, based on the input signal V_{IN}, a signal V_{LEAD} is generated at the drain terminal of the transistor M1 which leads the input signal V_{IN} in phase by a given phase shift Δφ_{LEAD} and a signal V_{LAG} is generated at the source terminal of the transistor M1 which lags the input signal V_{IN} in phase by a given phase shift Δφ_{LAG}.
A2. The polyphase filter circuitry of statement A1, wherein the signals V_{LEAD} and V_{LAG} of the common-source amplifier circuit are output signals of the polyphase filter circuitry.
A3. The polyphase filter circuitry of statement A1, comprising first and second said common-source amplifier circuits, wherein the signal V_{LEAD} of the first common-source amplifier circuit and the signal V_{LAG} of the second common-source amplifier circuit are output signals of the polyphase filter circuitry.
A4. The polyphase filter circuitry of statement A1, further comprising a source-follower circuit,
   wherein:
   the source-follower circuit comprises a field-effect transistor M1 with its gate terminal connected to the input node and with a capacitor C_{PPF} connected to its source terminal; and
   for the source-follower circuit, the output resistance R_{M1} seen at the source terminal of the field-effect transistor M1 and the capacitance of the capacitor C_{PPF} are configured to define the frequency response of the source-follower circuit so that, based on the input signal V_{IN}, a signal V_{LAG} is generated at the source terminal of the transistor M1 which lags the input signal V_{IN} in phase by a given phase shift Δφ_{LAG}.
A5. The polyphase filter circuitry of statement A4, wherein the signal V_{LEAD} of the common-source amplifier circuit and the signal V_{LAG} of the source-follower circuit are output signals of the polyphase filter circuitry.
A6. The polyphase filter circuitry of statement A4 or A5, wherein, for the source-follower circuit, the drain terminal of the transistor M1 is connected to a supply voltage node, optionally directly to that supply voltage node.
A7. The polyphase filter circuitry of any of the preceding statements, wherein, for each common-source amplifier circuit or source-follower circuit, the capacitor C_{PPF} is substantially directly connected to the source terminal of the field-effect transistor M1.
A8. The polyphase filter circuitry of any of the preceding statements, wherein, for each common-source amplifier circuit or source-follower circuit, the frequency response of that circuit is defined substantially (only) by the output resistance R_{M1} seen at the source terminal of the field-effect transistor M1 and the capacitance of the capacitor C_{PPF}.
A9. The polyphase filter circuitry of any of the preceding statements, wherein:
   each common-source amplifier circuit or source-follower circuit is, or functions as, or is equivalent to an RC filter circuit, optionally substantially a first-order RC filter circuit or a single-pole RC filter circuit; and/or
   each common-source amplifier circuit is a source-degenerated common-source amplifier circuit.
A10. The polyphase filter circuitry of any of the preceding statements, wherein, for each common-source amplifier circuit or source-follower circuit:
   the capacitor C_{PPF} is connected between, or substantially directly between, the source terminal of the transistor M1 and a supply voltage node; or
   the capacitor C_{PPF} is implemented as a capacitor C_{PPF1} connected between, or substantially directly between, the source terminal of the transistor M1 and a first supply voltage node and a capacitor C_{PPF2} connected between, or substantially directly between, the source terminal of the transistor M1 and a second supply voltage node.
A11. The polyphase filter circuitry of any of the preceding statements, wherein, for each common-source amplifier circuit or source-follower circuit:
   the capacitor C_{PPF}, or each of the capacitors C_{PPF1} and C_{PPF2}, is implemented as a MOS capacitor, optionally as a field-effect transistor configured as a MOS capacitor.
A12. The polyphase filter circuitry of any of the preceding statements, wherein, for each common-source amplifier circuit, a resistor R_{DRAIN} is connected between the drain terminal of the transistor M1 and a supply voltage node.
A13. The polyphase filter circuitry of statement A12, wherein, for each common-source amplifier circuit, the resistor R_{DRAIN} is implemented as a diode-connected field-effect transistor.
A14. The polyphase filter circuitry of statement A12 or A13, wherein, for each common-source amplifier circuit, a resistance of the resistor R_{DRAIN} is configured to determine a gain applied by that common-source amplifier circuit in generating its signal V_{LEAD} based on the input signal V_{IN}.
A15. The polyphase filter circuitry of any of the preceding statements, wherein, for each common-source amplifier circuit or source-follower circuit, a current source or a resistor is connected between the source terminal of the transistor M1 and a supply voltage node, optionally wherein that current source or resistor is implemented as a field-effect transistor.
A16. The polyphase filter circuitry of any of the preceding statements, wherein:
   for each common-source amplifier circuit or source-follower circuit, the field-effect transistors of the common-source amplifier circuit are of the same or similar type and/or of the same semiconductor fabrication process; and/or
   said field-effect transistors are of the same or similar type and/or of the same semiconductor fabrication process.
A17. The polyphase filter circuitry of any of the preceding statements, wherein:
   the input node is a first input node;
   the common-source amplifier circuit, or a combination of the first and second said common-source amplifier circuits, or a combination of the common-source amplifier circuit and the source-follower circuit, is a first-node filter circuit;
   the polyphase filter circuitry comprises a second input node configured to receive an input signal /V_{IN}, wherein V_{IN} and /V_{IN} are complementary signals; and
   the polyphase filter circuitry comprises a second-node filter circuit, substantially the same as the first-node filter circuit, whose gate terminals are connected to the second input node rather than to the first input node so that signals /V_{LAG} and /V_{LEAD} are generated instead of signals V_{LAG} and V_{LEAD}, respectively, wherein signals /V_{LAG} and /V_{LEAD} are complementary signals of signals V_{LAG} and V_{LEAD}, respectively.
A18. The polyphase filter circuitry of any of the preceding statements, wherein the given phase shifts for the output signals of the polyphase filter circuitry, or for at least two said output signals, are substantially the same as one another, and optionally are 45° phase shifts.
A19. Polyphase filter circuitry, comprising:
   an input node configured to receive an input signal V_{IN} having a dominant frequency f_{PPF}; and
   first and second source-follower circuits,
   wherein:
      each source-follower circuit comprises a field-effect transistor M1 with its gate terminal connected to the input node and with a capacitor C_{PPF} connected to its source terminal;
      for each source-follower circuit, the output resistance R_{M1} seen at the source terminal of the field-effect transistor M1 and the capacitance of the capacitor C_{PPF} are configured to define the frequency response of the source-follower circuit so that, based on the input signal V_{IN}, a signal V_{LAG} is generated at the source terminal of the transistor M1 which lags the input signal V_{IN} in phase by a given phase shift Δφ_{LAG};
      the given phase shifts Δφ_{LAG} for the first and second source-follower circuits are different from one another; and
      the signals V_{LAG} of the first and second source-follower circuits are output signals of the polyphase filter circuitry.
A20. Multi-phase clock generation circuitry comprising:
   the polyphase filter circuitry of any of the preceding statements; and
   a source clock generation circuit configured to generate and provide to the polyphase filter circuitry the input signal V_{IN} as a source clock signal, or the input signals V_{IN} and /V_{IN} as source clock signals, the output signals of the polyphase filter circuitry being output clock signals of the multi-phase clock generation circuitry having different relative phases from one another.
A21. Clocked circuitry, comprising:
   the multi-phase clock generation circuitry of statement A20; and
   one or more clocked circuits connected to receive the output clock signals and operate based thereon.
A22. The clocked circuitry of statement A21, being or comprising at least one of:
   quadrature oscillator circuitry;
   phase lock loop circuitry;
   clock data recovery circuitry;
   analogue-to-digital converter circuitry;
   digital-to-analogue converter circuitry;
   Serializer/Deserializer circuitry;
   a wireless transceiver;
   a processor; and
   IQ phase generation circuitry; and
   clocking circuitry.
A23. Integrated circuitry, such as an IC chip, comprising the polyphase filter circuitry of any of statements A1 to A19, or the multi-phase clock generation circuitry of statement A20, or the clocked circuitry of statement A21 or A22.
B1. A source-follower circuit, comprising:
   an input node configured to receive an input signal V_{IN} having a dominant frequency f_{PPF};
   a field-effect transistor M1 with its gate terminal connected to the input node; and
   a capacitor C_{PPF} connected to the source terminal of the field-effect transistor M1,
   wherein:
      the output resistance R_{M1} seen at the source terminal of the field-effect transistor M1 and the capacitance of the capacitor C_{PPF} are configured to define the frequency response of the source-follower circuit so that, based on the input signal V_{IN}, a signal V_{LAG} is generated at the source terminal of the transistor M1 which lags the input signal V_{IN} in phase by a given phase shift Δφ_{LAG};
      the capacitor C_{PFF} is substantially directly connected between the source terminal of the field-effect transistor and a supply voltage node and is implemented as a MOS capacitor.
B2. The source-follower circuit of statement B1, wherein the capacitor C_{PPF} is implemented as a field-effect transistor configured as the MOS capacitor.
B3. The source-follower circuit of statement B1, wherein:
   the capacitor C_{PPF} is implemented as a capacitor C_{PPF1} connected between, or substantially directly between, the source terminal of the transistor M1 and a first supply voltage node, and a capacitor C_{PPF2} connected between, or substantially directly between, the source terminal of the transistor M1 and a second supply voltage node; and
   the capacitor C_{PPF}, or each of the capacitors C_{PPF1} and C_{PPF2}, is implemented as a field-effect transistor configured as a MOS capacitor.
B4. The source-follower circuit of any of claims B1 to B3, wherein:
   a current source or a resistor is connected between the source terminal of the transistor and a supply voltage node, optionally wherein that current source or resistor is implemented as a field-effect transistor.
B5. The source-follower circuit of any of claims B1 to B4, wherein:
   the drain terminal of the transistor is connected directly to its supply voltage node.
B6. The source-follower circuit of any of claims B1 to B5, wherein the field-effect transistors are of the same or similar type and/or of the same semiconductor fabrication process.
B7. A common-source amplifier circuit, comprising:
   the source-follower circuit of any of claims X1 to X4; and
   a resistor R_{DRAIN} connected between the drain terminal of the transistor and a supply voltage node,
   optionally wherein a signal V_{LEAD} is generated at the drain terminal of the transistor M1 which leads the input signal V_{IN} in phase by a given phase shift Δφ_{LEAD}.
B8. The common-source amplifier circuit of statement B7, wherein the resistor R_{DRAIN} is implemented as a diode-connected field-effect transistor.
B9. The common-source amplifier circuit of statement B7 or B8, wherein the field-effect transistors are of the same or similar type and/or of the same semiconductor fabrication process.
C1. A source-follower circuit, comprising:
   an input node configured to receive an input signal V_{IN};
   a field-effect transistor M1 with its gate terminal connected to the input node; and
   a capacitor C_{PPF} connected to the source terminal of the field-effect transistor M1,
   wherein:
      the capacitor C_{PFF} is substantially directly connected between the source terminal of the field-effect transistor and a supply voltage node and is implemented as a MOS capacitor.
C2. A common-source amplifier circuit, comprising:
   the source-follower circuit of statement C1; and
   a resistor R_{DRAIN} connected between the drain terminal of the transistor and a supply voltage node.

## Claims

1. Polyphase filter circuitry, comprising:
an input node configured to receive an input signal V_{IN} having a dominant frequency f_{PPF}; and
a common-source amplifier circuit,
wherein:
the common-source amplifier circuit comprises a field-effect transistor M1 with its gate terminal connected to the input node and with a capacitor C_{PFF} connected to its source terminal; and
for the common-source amplifier circuit, the output resistance R_{M1} seen at the source terminal of the field-effect transistor M1 and the capacitance of the capacitor C_{PFF} are configured to define the frequency response of the common-source amplifier circuit so that, based on the input signal V_{IN}, a signal V_{LEAD} is generated at the drain terminal of the transistor M1 which leads the input signal V_{IN} in phase by a given phase shift Δφ_{LEAD} and a signal V_{LAG} is generated at the source terminal of the transistor M1 which lags the input signal V_{IN} in phase by a given phase shift Δφ_{LAG}.

2. The polyphase filter circuitry of claim 1, further comprising a source-follower circuit, wherein:
the source-follower circuit comprises a field-effect transistor M1 with its gate terminal connected to the input node and with a capacitor C_{PPF} connected to its source terminal;
for the source-follower circuit, the output resistance R_{M1} seen at the source terminal of the field-effect transistor M1 and the capacitance of the capacitor C_{PPF} are configured to define the frequency response of the source-follower circuit so that, based on the input signal V_{IN}, a signal V_{LAG} is generated at the source terminal of the transistor M1 which lags the input signal V_{IN} in phase by a given phase shift Δφ_{LAG}; and
the signal V_{LEAD} of the common-source amplifier circuit and the signal V_{LAG} of the source-follower circuit are output signals of the polyphase filter circuitry.

3. The polyphase filter circuitry of any of the preceding claims, wherein, for each common-source amplifier circuit or source-follower circuit:
the capacitor C_{PPF} is connected between, or substantially directly between, the source terminal of the transistor M1 and a supply voltage node; or
the capacitor C_{PPF} is implemented as a capacitor C_{PPF1} connected between, or substantially directly between, the source terminal of the transistor M1 and a first supply voltage node and a capacitor C_{PPF2} connected between, or substantially directly between, the source terminal of the transistor M1 and a second supply voltage node.

4. The polyphase filter circuitry of any of the preceding claims, wherein, for each common-source amplifier circuit or source-follower circuit:
the capacitor C_{PPF}, or each of the capacitors C_{PPF1} and C_{PPF2}, is implemented as a MOS capacitor, optionally as a field-effect transistor configured as a MOS capacitor.

5. The polyphase filter circuitry of any of the preceding claims, wherein, for each common-source amplifier circuit, a resistor R_{DRAIN} is connected between the drain terminal of the transistor M1 and a supply voltage node,
wherein, for each common-source amplifier circuit, the resistor R_{DRAIN} is implemented as a diode-connected field-effect transistor.

6. The polyphase filter circuitry of any of the preceding claims, wherein, for each common-source amplifier circuit or source-follower circuit, a current source or a resistor is connected between the source terminal of the transistor M1 and a supply voltage node, optionally wherein that current source or resistor is implemented as a field-effect transistor.

7. The polyphase filter circuitry of any of the preceding claims, wherein:
for each common-source amplifier circuit or source-follower circuit, the field-effect transistors of the common-source amplifier circuit are of the same or similar type and/or of the same semiconductor fabrication process; and/or
said field-effect transistors are of the same or similar type and/or of the same semiconductor fabrication process.

8. Multi-phase clock generation circuitry comprising:
the polyphase filter circuitry of any of the preceding claims; and
a source clock generation circuit configured to generate and provide to the polyphase filter circuitry the input signal V_{IN} as a source clock signal, the output signals of the polyphase filter circuitry being output clock signals of the multi-phase clock generation circuitry having different relative phases from one another.

9. A source-follower circuit, comprising:
an input node configured to receive an input signal V_{IN} having a dominant frequency f_{PPF};
a field-effect transistor M1 with its gate terminal connected to the input node; and
a capacitor C_{PPF} connected to the source terminal of the field-effect transistor M1,
wherein:
the output resistance R_{M1} seen at the source terminal of the field-effect transistor M1 and the capacitance of the capacitor C_{PPF} are configured to define the frequency response of the source-follower circuit so that, based on the input signal V_{IN}, a signal V_{LAG} is generated at the source terminal of the transistor M1 which lags the input signal V_{IN} in phase by a given phase shift Δφ_{LAG}; and
the capacitor C_{PFF} is substantially directly connected between the source terminal of the field-effect transistor and a supply voltage node and is implemented as a MOS capacitor.

10. The source-follower circuit of claim 9, wherein the capacitor C_{PPF} is implemented as a field-effect transistor configured as the MOS capacitor.

11. The source-follower circuit of claim 9, wherein:
the capacitor C_{PPF} is implemented as a capacitor C_{PPF1} connected between, or substantially directly between, the source terminal of the transistor M1 and a first supply voltage node, and a capacitor C_{PPF2} connected between, or substantially directly between, the source terminal of the transistor M1 and a second supply voltage node; and
the capacitor C_{PPF}, or each of the capacitors C_{PPF1} and C_{PPF2}, is implemented as a field-effect transistor configured as a MOS capacitor.

12. The source-follower circuit of any of claims 9 to 11, wherein:
a current source or a resistor is connected between the source terminal of the transistor and a supply voltage node, optionally wherein that current source or resistor is implemented as a field-effect transistor.

13. The source-follower circuit of any of claims 9 to 12, wherein:
the drain terminal of the transistor is connected directly to its supply voltage node.

14. The source-follower circuit of any of claims 9 to 13, wherein the field-effect transistors are of the same or similar type and/or of the same semiconductor fabrication process.

15. Integrated circuitry, such as an IC chip, comprising the polyphase filter circuitry of any of claims 1 to 7, or the multi-phase clock generation circuitry of claim 8, or the source-follower circuit of any of claims 9 to 14.
